Europäisches Patentamt

European Patent Office

Office européen des brevets

(19)

(11) **EP 0 780 982 A1**

## (12) EUROPÄISCHE PATENTANMELDUNG

(43) Veröffentlichungstag:
**25.06.1997 Patentblatt 1997/26**

(51) Int. Cl.$^6$: **H03K 19/00**

(21) Anmeldenummer: **96120620.8**

(22) Anmeldetag: **20.12.1996**

(84) Benannte Vertragsstaaten:
**DE FR NL**

(30) Priorität: **23.12.1995 DE 19548629**

(71) Anmelder: **Deutsche ITT Industries GmbH**
**79108 Freiburg (DE)**

(72) Erfinder: **Witte, Franz-Otto, Dr.-Ing.**
**79312 Emmendingen (DE)**

(54) **Komplementäres Taktsystem**

(57)     Komplementäres Taktsystem für gegenphasige Takte mit einem Taktgenerator (4) für einen ersten und zweiten Takt (t3, t4), wobei eine erste und zweite Treiberstufe (1, 2) an zwei Taktleitungen (9.1, 9.2) angeschlossen sind, deren kapazitive Belastung einer ersten bzw. zweiten Lastkapazität (c1, c2) entspricht, ein schaltbarer Strompfad (5) zwischen der ersten und zweiten Taktleitung (9.1, 9.2) liegt, dessen Stromflußzeit mittels einer Torschaltung (8) im wesentlichen während der Schaltintervalle (ti) des ersten und zweiten Taktes (t3, t4) in den leitenden Zustand gesteuert ist und der mindestens ein induktives Element (7.1, 7.2) enthält.

FIG. 2

EP 0 780 982 A1

**Beschreibung**

Die Erfindung betrifft ein komplementäres Taktsystem für gegenphasige Takte, die bei getakteten Logiksystemen mit monolithisch integrierten Schaltungen, insbesondere CMOS-Shaltungen, verwendet werden. Es ist bekannt, daß dabei sehr hohe Lastströme auf den Versorgungsleitungen fließen können, wobei die Lastströme im wesentlichen durch die ständige Auf- und Entladung der Gate-Kapaziäten bedingt sind und direkt proportional mit der Taktfrequenz zunehmen. Außer einer hohen Kristalltemperatur infolge der Verlustleistung machen sich die Lastströme besonders unangenehm über ihre Störstrahlung bemerkbar. Eine kapazitive Pufferung der Stromspitzen an den äußeren Schaltungsanschlüssen ist unbefriedigend, weil der Weg über die Anschlußbeine bereits zu lang ist. Mit zunehmenden Taktfrequenzen nehmen diese Schwierigkeiten immer mehr zu.

Es ist daher Aufgabe der Erfindung ein komplementäres Taktsystem für gegenphasige Takte anzugeben, bei dem die in den Versorgungsleitungen fließenden Lastströme in den Spitzenwerten, aber auch im zeitlichen Mittelwert reduziert sind, ohne die Geschwindigkeit der Signalverarbeitung herabzusetzen.

Die Lösung der Aufgabe erfolgt nach der Erfindung durch ein komplementäres Taktsystem für gegenphasige Takte, das durch die Merkmale des Anspruchs 1 wie folgt definiert ist:

- ein Taktgenerator für einen ersten und zweiten Takt,
- eine erste bzw. eine zweite Treiberstufe, an die eine erste bzw. zweite Taktleitung angeschlossen ist, wobei deren kapazitive Belastung einer ersten bzw. einer zweiten Lastkapazität entspricht, und
- ein schaltbarer Strompfad zwischen der ersten und zweiten Taktleitung, dessen Stromflußzeit mittels einer im schaltbaren Strompfad liegenden Torschaltung gesteuert ist, wobei der schaltbare Strompfad mindestens ein induktives Element enthält und die Torschaltung im wesentlichen während der Schaltintervalle des ersten und zweiten Taktes in den leitenden Zustand gesteuert ist.

Die Erfindung geht von dem Grundgedanken aus, daß bei den üblichen Treiberstufen der Aufladestrom für die eine Lastkapazität aus der positiven Versorgungsquelle gespeist und der Entladestrom nach der negativen Versorgungsquelle oder nach Masse abgeleitet wird. Nahezu gleichzeitig fließt der Entlade- bzw. Aufladestrom für die andere Lastkapazität in die jeweils entgegengesetzte Richtung. Durch die Erfindung kann ein Teil dieser Ströme dazu dienen, während des Schaltintervalls die jeweils andere Lastkapazität anfänglich aufzuladen oder zu entladen. Dies wird durch einen schaltbaren Strompfad erreicht, der zwischen den beiden Taktleitungen eingefügt ist und im geeigneten Zeitintervall, also zu Beginn der Auf- oder Entladung, leitend geschaltet wird. Hierzu wäre allerdings ein sehr kurzer und zeitlich genau liegender Torimpuls erforderlich. Eine erhebliche Verbesserung des Verhaltens wird durch eine induktive Ausbildung des geschalteten Strompfades erreicht, weil dadurch eine Energiespeicherung eintritt und der Stromfluß auch noch beibehalten wird, wenn die Potentiale in den beiden Lastkapazitäten einander gleich sind oder bereits eine Gegenspannung vorhanden ist. Da sich diese Vorgänge im dynamischen Bereich abspielen, ist ihre Anwendung nur für hohe Taktfrequenzen interessant, dort jedoch um so mehr.

Von Vorteil ist es dabei, wenn die Schaltungsanordung so gewählt wird, daß durch die Induktivität des geschalteten Strompfades und die Lastkapazitäten ein Schwingkreis gebildet wird, dessen Resonanzfrequenz bzw. halbe Periodendauer etwa mit der Dauer der Schaltflanken des Taktes übereinstimmt. Dann wird der geschaltete Strompfad für jeweils eine Halbschwingung leitend geschaltet, so daß ein Teil der in der einen Lastkapazität gespeicherten Ladung in die andere Lastkapazität fließen kann, wobei der Öffungszeitpunkt der Schwingkreisschleife jeweils möglichst im stromlosen Zustand erfolgt. Die restliche Auf- oder Entladung erfolgt dann durch die üblichen Treiberstufen.

Während der Stromflußzeit des geschalteten Strompfades sollten die Treiberstufen möglichst von den Versorgungsquellen getrennt oder entkoppelt sein, damit der Schwingkreis nicht niederohmig kurzgeschlossen wird. Der besseren Übersicht wegen sind jedoch entsprechende Unterbrecher- oder Entkoppelschaltungen in dem Ausführungsbeispiel nicht dargestellt, sie erübrigen sich zudem, wenn die Zuleitungen zu den Treiberstufen in diesem Frequenzbereich bereits als Drossel wirken.

Von weiterem Vorteil ist, daß die Dauer der erforderlichen Torzeit mit der für die jeweilige Technologie zulässigen Taktfrequenz verkoppelt ist, weil die Dauer der Schaltflanken ebenfalls von der jeweiligen Technologie abhängig sind.

Die Erfindung und ein vorteilhaftes Ausführungsbeispiel wird nun anhand der Figuren der Zeichnung näher erläutert:

Fig. 1 zeigt schematisch ein bekanntes Taktsystem,
Fig. 2 zeigt schematisch ein Taktsystem nach der Erfindung,
Fig. 3 zeigt typische Signale des bekannten Taktsystems und
Fig. 4 zeigt typische Signale des Taktsystems nach der Erfindung.

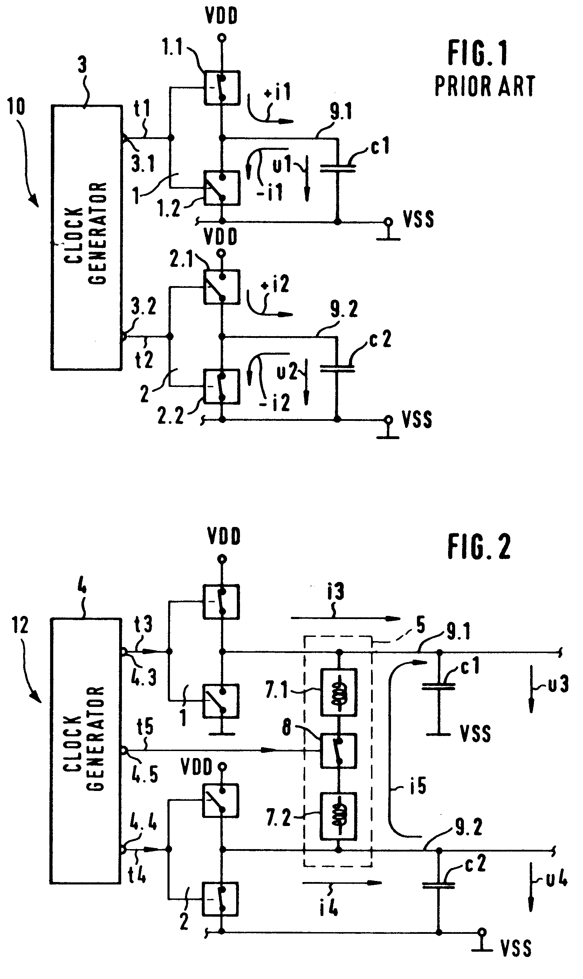

In Fig. 1 liefert eine Taktgenerator 3 gegenphasige und nichtüberlappende Taktsignale t1, t2 über einen ersten bzw. zweiten Ausgang 3.1, 3.2 an eine erste bzw. zweite Treiberstufe 1,2. Diese enthalten jeweils ein Gegentaktschaltungspaar 1.1, 1.2 bzw. 2.1, 2.2, die von einer positiven und negativen Versorgungsspannung VDD, VSS niederohmig gespeist sind. Am Ausgang der Treiberstufen ist jeweils eine Taktleitung angeschlossen, die die Verbindung zu einer ersten bzw. zweiten Lastkapazität c1, c2 bildet. Durch die Lastkapazitäten werden die Gate-Kapazitäten der angeschlossenen Transistoren ersatzweise dargestellt. Die Auf- oder Entladung der Lastkapazitäten erfolgt durch einen ersten bzw. zweiten Laststrom i1, i2, wobei die positive Stromrichtung der Aufladung entspricht.

Die in Fig. 2 dargestellte Schaltung enthält im wesentlichen die gleichen Elemente wie Fig. 1, vergleiche auch die gleichen Bezugszeichen. Sofern eine Übereinstimmung vorliegt, erübrigt sich somit eine nochmalige Erörterung. Der Taktgenerator 4 hat außer den Ausgängen 4.3, 4.4 für das erste bzw. zweite Taktsignal t3, t4 einen weiteren Ausgang 4.5 für ein Torsignal t5. Ferner enthält die Schaltung einen schaltbaren Strompfad 5 zwischen der ersten und zweiten Taktleitung 9.1, 9.2. Der Strompfad 5 enthält in Serienschaltung eine erstes induktives Element 7.1, eine Torschaltung 8 und ein zweites induktives Element 7.2. Der Steuereingang der Torschaltung 8 ist mit dem Torsignalausgang 4.5 des Taktgenerators 4 verbunden. Die beiden induktiven Elemente 7.1, 7.2 bilden zusammen eine Induktivität L, die lediglich der besseren Symmetrie der Schaltung wegen aufgeteilt ist. Die mit den Treiberstufen 1, 2 jeweils verkoppelten Ströme i3, i4 sind als Pfeile dargestellt und definieren die positive Stromrichtung. Der Strom durch den geschalteten Strompfad 5 ist für die positive Richtung als Pfeil i5 dargestellt. Aus der Fig. 2 ist leicht ersichtlich, daß die Serienschaltung aus den beiden Lastkapazitäten c1, c2 , die im folgenden einfach als Kapazität C bezeichnet wird, mit der Induktivität L einen Schwingkreis bildet, der über die Torschaltung 8 und die gemeinsame Masseverbindung VSS geschlossen ist. Die bekannte Formel für die Resonanzfrequenz fr ist:

$$fr = 1/(2\pi \cdot SQR(L \cdot C))$$

Die Größe der Lastkapazitäten c1, c2 hängt außer der Technologie insbesondere direkt von dem jeweiligen Schaltungsumfang ab. Der Wert kann bei großen Schaltungen ohne weiteres zwischen 40 pF und 80 pF liegen. Ein überschlägige Berechung zeigt, daß für eine Flankendauer von 2 ns bis 6 ns, die etwa einer Taktfrequenz von einigen 100 MHz entspricht, eine Induktivität von 1 nH bis 2 nH erforderlich ist. Dies entspricht einer Bonddraht-Verbindung mit einer Gesamtlänge von etwa 1 mm bis 2 mm. Das sind durchaus realisierbare Größenordnungen, die mit einer monolithisch integrierten Schaltung zusammenpassen. Beispielsweise kann auf separaten Bondkontakten auf dem Chip diese Bondung als Einfach- oder Mehrfach-Bondung ausgeführt werden. Selbstverständlich lassen sich derartig kleine Induktivitäten auch über flächenförmige Spulenanordnungen aus einer oder mehreren Metallisierungsschichten oder auf andere Weise realisieren.

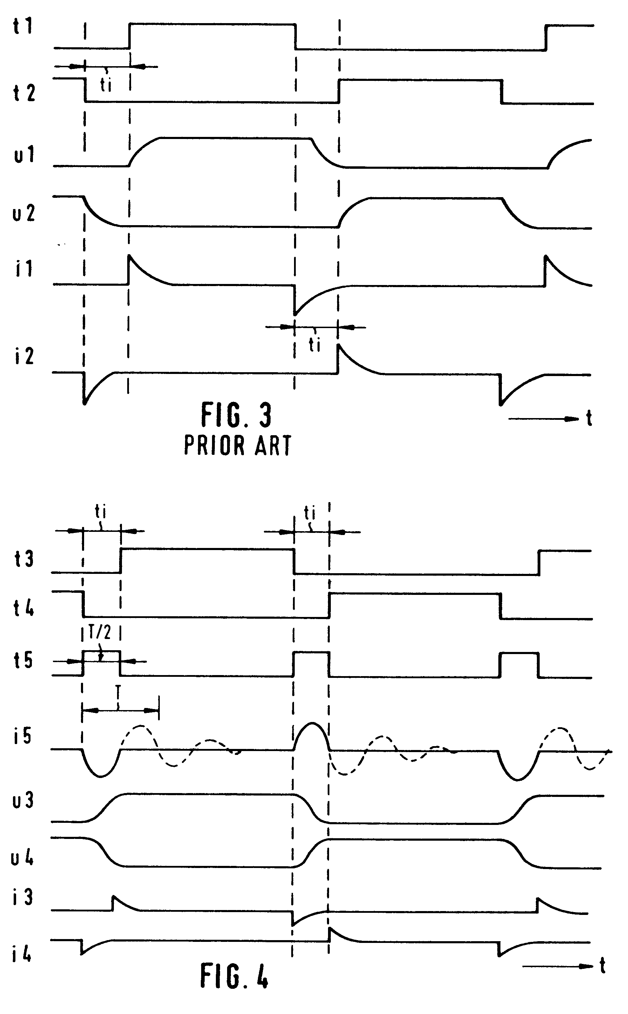

In Fig. 3 sind im Zeitdiagramm die wesentlichen Signale des bekannten Taktsystems von Fig. 1 dargestellt. Aus den beiden nichtüberlappenden und gegenphasigen Taktsignalen t1, t2 resultieren die Spannungsverläufe u1, u2 an der ersten bzw. zweiten Lastkapazität c1, c2. Die zugehörigen Auf- und Entladeströme i1, i2 zeigen, welche Lastkapazität jeweils entladen oder aufgeladen wird. Der Nichtüberlappungsbereich ist dabei im wesentlichen durch das Schaltintervall ti des ersten und zweiten Taktes t1, t2 vorgegeben.

In Fig. 4 sind die beiden Takte t3, t4 ebenfalls gegenphasig und nicht überlappend, wobei im Schaltintervall ti beide Takte gleichzeitig auf dem Nullpotential liegen. Die Funktionsweise des geschalteten Strompfades 5 setzt voraus, daß eine Spannungsdifferenz zwischen der ersten und zweiten Taktleitung 9.1, 9.2 vorliegt, weil ansonsten auch kein Ausgleichsstrom i5 fließen kann. Das Torsignal t5, das etwa zeitlich mit dem Schaltintervall ti identisch ist, schaltet im Ein-Zustand den Strompfad 5 leitend, so daß der Ausgleichstrom i5 fließen kann. Durch die Dämpfungselemente im Resonanzkreis würde die angeregte Schwingung abklingen, dies ist schematisch im Diagramm i5 durch die unterbrochenen Schwingungszüge dargestellt. Wird nach einer halben Schwingung, also nach einer halben Periode T/2 die Torschaltung 8 wieder geöffnet, dann bleibt der Ausgleichsstrom i5 auf dem Nullwert, bis ein neuer Torimpuls beim neuen Flankenwechsel den Resonanzkreis wieder schließt. Der Torimpuls im Torsignal t5 tritt mit der doppelten Frequenz der beiden Takte t1, t2 auf.

Der resultierende Spannungsverlauf u3, u4 an den beiden Lastkapazitäten c1, c2 zeigt, daß der Überschneidungspunkt etwa bei der halben Flankenspannung liegt. Das ist für eine sichere Betriebsweise im Hochgeschwindigkeitsbereich noch ausreichend. Die Stromimpulse i3, i4, die mit den Treiberstufen 1,2 verkoppelt sind, sind deutlich kleiner als die entsprechenden Stromimpulse i1, i2 in Fig. 3, weil ein Teil der Auf- oder Entladung durch den Ausgleichsstrom i5 erfolgt. Der Ausgleichsstrom i5 erzeugt nur ein ganz geringes Störfeld, weil die Strahlungsfläche auf die monolithisch integrierte Schaltung beschränkt und daher sehr klein ist. Die Stromimpulse i3, i4, die über die Versorgungsleitungen fließen müssen, sind reduziert, so daß die Störstrahlung wie gewünscht kleiner geworden ist. Auch die Wärmeentwicklung hat in der Schaltung abgenommen, da der Ausgleichsstrom i5 nur die Differenzspannung zwischen den beiden Taktleitungen 9.1, 9.2 überwinden muß. Die beiden Spannungen u3, u4 gleichen sich während des Flankenwechsel jedoch zunächst einander an, bevor sie ihre neue Gegenphasenlage annehmen. Damit ist die verbleibende Verlustleistung insgesamt deutlich reduziert.

**Patentansprüche**

1. Komplementäres Taktsystem für gegenphasige Takte mit einem Taktgenerator (4) für einen ersten und zweiten Takt (t3, t4),

   - einer ersten und einer zweiten Treiberstufe (1, 2), an die eine erste bzw. zweite Taktleitung (9.1, 9.2) angeschlossen ist, wobei deren kapazitive Belastung einer ersten bzw. zweiten Lastkapazität (c1, c2) entspricht, und mit

- einem schaltbaren Strompfad (5) zwischen der ersten und zweiten Taktleitung (9.1, 9.2), dessen Stromflußzeit mittels einer im schaltbaren Strompfad (5) liegenden Torschaltung (8) gesteuert ist, wobei der schaltbare Strompfad (5) mindestens ein induktives Element (7.1, 7.2) enthält und die Torschaltung (8) im wesentlichen während eines dem Nichtüberlappungszustand zugeordneten Schaltintervalles (ti) des ersten und zweiten Taktes (t3, t4) in den leitenden Zustand gesteuert ist.

2. Komplementäres Taktsystem nach Anspruch 1, dadurch gekennzeichnet, daß die Torschaltung (8) durch ein Torsignal (t5) des Taktgenerators (4) gesteuert ist.

3. Komplementäres Taktsystem nach Anspruch 1 oder 2, dadurch gekennzeichnet, daß das induktive Element oder die induktiven Elemente (7.1, 7.2) eine Induktivität L darstellen, die so vorzugeben ist, daß die Induktivität L zusammen mit der ersten und/oder zweiten Lastkapazität (c1, c2) einen Schwingkreis bildet, dessen halbe Periode T/2 in der Größenordnung der Auf- oder Entladezeit der ersten oder zweiten Lastkapazität (c1, c2) liegt, wobei die Torschaltung (8) jeweils nach einem Teil der Schwingkreisperiode T wieder in den Sperrzustand geschaltet ist.

4. Komplementäres Taktsystem nach einem der Ansprüche 1 bis 3, dadurch gekennzeichnet, daß es zusammen mit einer taktgesteuerten CMOS-Schaltung monolithisch integriert ist.

5. Komplementäres Taktsystem nach einem der Ansprüche 1 bis 4, dadurch gekennzeichnet, daß das induktive Element (7.1, 7.2) mindestens eine Bonddrahtverbindung enthält.

6. Komplementäres Taktsystem nach einem der Ansprüche 1 bis 4, dadurch gekennzeichnet, daß das induktive Element (7.1, 7.2) mindestens teilweise im Bereich der Halbleiteroberfläche, insbesondere mittels eines Halbleiterherstellungsprozesses, ausgebildet ist.

7. Komplementäres Taktsystem nach Anspruch 6, dadurch gekennzeichnet, daß das induktive Element (7.1, 7.2) spulenförmig ausgebildete Halbleiter- und/oder Metallisierungszonen enthält.

**FIG.1**
**PRIOR ART**

**FIG.2**

5

t 1

t 2

u 1

u 2

i 1

i 2

ti

ti

# FIG. 3
## PRIOR ART

⟶ t

ti

ti

t 3

t 4

t 5

T/2

T

i 5

u 3

u 4

i 3

i 4

# FIG. 4

⟶ t

EP 0 780 982 A1

**Europäisches Patentamt**

# EUROPÄISCHER RECHERCHENBERICHT

Nummer der Anmeldung

EP 96 12 0620

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| Y | WO 94 15394 A (HARVEY GEOFFREY PHILIP) 7.Juli 1994<br>* Seite 11, Zeile 1 - Seite 19, Zeile 15 *<br>* Seite 21, Zeile 22 - Zeile 32 *<br>* Abbildungen 3,4,14,15,22 *<br>--- | 1-7 | H03K19/00 |
| Y | PATENT ABSTRACTS OF JAPAN<br>vol. 014, no. 518 (E-1001), 14.November 1990<br>& JP 02 216910 A (FUJITSU LTD), 29.August 1990,<br>* Zusammenfassung *<br>--- | 1-7 | |
| A | US 5 311 136 A (TAKAHASHI FUMIKAZU) 10.Mai 1994<br>* Zusammenfassung *<br>* Spalte 9, Zeile 46 - Zeile 63 *<br>* Abbildungen 7,9 *<br>--- | 1 | |
| A | DE 44 30 078 A (GEKELER MANFRED PROF DR ING) 2.Februar 1995<br>* Zusammenfassung *<br>* Spalte 3, Zeile 31 - Spalte 5, Zeile 13 *<br>* Abbildungen 1,2 *<br>--- | 1 | **RECHERCHIERTE SACHGEBIETE (Int.Cl.6)** |
| A | EP 0 680 148 A (AT & T CORP) 2.November 1995<br>* Spalte 2, Zeile 25 - Spalte 8, Zeile 15 *<br>* Abbildungen 2,5 *<br>--- | 1 | H03K<br>H01L |
| A | EP 0 395 146 A (PHILIPS NV) 31.Oktober 1990<br>* das ganze Dokument *<br>---<br>-/-- | 1 | |

Der vorliegende Recherchenbericht wurde für alle Patentansprüche erstellt

| Recherchenort | Abschlußdatum der Recherche | Prüfer |
|---|---|---|
| DEN HAAG | 26.März 1997 | Jepsen, J |

EPO FORM 1503 03.82 (P04C03)

Europäisches
Patentamt

**EUROPÄISCHER RECHERCHENBERICHT**

Nummer der Anmeldung

EP 96 12 0620

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| P,X | US 5 508 639 A (FATTARUSO JOHN W) 16.April 1996<br>* das ganze Dokument *<br>----- | 1 | |
| | | | **RECHERCHIERTE SACHGEBIETE (Int.Cl.6)** |

Der vorliegende Recherchenbericht wurde für alle Patentansprüche erstellt

| Recherchenort | Abschlußdatum der Recherche | Prüfer |
|---|---|---|
| DEN HAAG | 26.März 1997 | Jepsen, J |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
............................................................................................
& : Mitglied der gleichen Patentfamilie, übereinstimmendes
    Dokument

EPO FORM 1503 03.82 (P04C03)